(19) Europäisches Patentamt
European Patent Office
Office européen des brevets

(11) **EP 2 582 044 B1**

(12) **EUROPÄISCHE PATENTSCHRIFT**

(45) Veröffentlichungstag und Bekanntmachung des Hinweises auf die Patenterteilung:
**25.03.2015 Patentblatt 2015/13**

(51) Int Cl.:
***H03F 3/217*** *(2006.01)*

(21) Anmeldenummer: **12006937.2**

(22) Anmeldetag: **06.10.2012**

(54) **Messung des Ausgangstroms einer Verstärkerschaltung**

Measurement of the output current of an amplifier circuit

Mesure du courant de sortie d'un circuit d'amplification

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.10.2011 DE 102011115503**

(43) Veröffentlichungstag der Anmeldung:
**17.04.2013 Patentblatt 2013/16**

(73) Patentinhaber: **Airbus DS GmbH**
**82024 Taufkirchen (DE)**

(72) Erfinder: **Rapp, Udo**
**88677 Markdorf (DE)**

(74) Vertreter: **Avenhaus, Beate**
**Airbus Defence and Space GmbH**
**Patentabteilung**
**81663 München (DE)**

(56) Entgegenhaltungen:
**US-A1- 2004 000 895     US-A1- 2004 056 644**
**US-A1- 2011 050 185     US-B1- 7 372 238**

- **KAGERBAUER J D ET AL: "Development of an Active dv/dt Control Algorithm for Reducing Inverter Conducted EMI with Minimal Impact on Switching Losses", POWER ELECTRONICS SPECIALISTS CONFERENCE, 2007. PESC 2007. IEEE, IEEE, PISCATAWAY, NJ, USA, 17. Juni 2007 (2007-06-17), Seiten 894-900, XP031218403, ISBN: 978-1-4244-0654-8**

EP 2 582 044 B1

**Beschreibung**

Die Erfindung betrifft eine Verstärkerschaltung gemäß Anspruch 1.

Zur Stromversorgung elektrischer Antrieb können getaktete Klasse-D-Verstärker eingesetzt werden. Derartige Verstärker werden in der Regel mittels Pulsweiten-Modulation (PWM) angesteuert und stellen meist über ein LC-Filter einen elektrischen Ausgangsstrom zur Versorgung eines elektrischen Antriebs zu Verfügung. Vorteile getakteter Klasse-D-Verstärker bestehen vor allem in ihrem hohen Wirkungsgrad und den geringen Wärmeverlusten.

Die Messung des Ausgangsstroms beispielsweise zur Regelung oder Steuerung eines elektrischen Antriebs kann über einen Shuntwiderstand oder einen Transformator mit nachfolgendem analogem Regler erfolgen. Derartige Schaltungskonzepte besitzen allerdings eine geringe Flexibilität, da sie an bestimmte Messbereiche angepasst sein müssen. Beispielsweise muss ein Shuntwiderstand entsprechend dem zu messenden Strombereich ausgewählt werden. Außerdem führen diese Schaltungskonzepte zu einem hohen Schaltungs- und Abgleichaufwand.

Anstelle eines analogen Reglers kann auch ein Analog-Digital-Wandler eingesetzt werden, der beispielsweise über einen Multiplexer die Stromkanäle mehrerer Verstärker messen kann. Ein solches Konzept bedingt allerdings ebenfalls einen hohen Schaltungsaufwand, der in bestimmten Anwendungsgebieten wie beispielsweise in der Raumfahrt nachteilig ist, da hier nur eine geringe Auswahl an qualifizierten Bauteilen verfügbar ist.

Eine Aufgabe der vorliegenden Erfindung besteht nun darin, eine Verstärkerschaltung anzugeben, die eine Messung ihres Ausgangsstroms mit einem möglichst geringen Schaltungsaufwand ermöglicht.

Diese Aufgabe wird durch eine Verstärkerschaltung mit den Merkmalen von Anspruch 1 gelöst. Weitere Ausgestaltungen der Erfindung sind Gegenstand der abhängigen Ansprüche.

Ein der Erfindung zugrunde liegender Gedanke besteht darin, die beim Schalten von Schaltelementen einer Endstufe einer Verstärkerschaltung, insbesondere eines Klasse-D-Verstärkers, auftretenden Schaltflanken zu vermessen, und anhand dieser Messungen den Ausgangsstrom der Verstärkerschaltung zu ermitteln. Um Toleranzeinflüsse der Schaltelemente, die durch Transistoren implementiert sein können, zu minimieren, kann zumindest einem der Schaltelemente ein kapazitives Element, insbesondere ein Kondensator, parallel geschaltet werden. Da die Schaltflanke eines realen Schaltelements wie eines Transistors ihre Steilheit abhängig vom (zu messenden) Endstufen- bzw. Ausgangsstrom ändert, kann durch die Messung der Schaltflanke auf den Ausgangsstrom geschlossen werden. Eine Schaltflanke kann insbesondere durch eine Messung einer Verzögerungszeit einer ansteigenden oder abfallenden Spannungsflanke ermittelt werden. Zur Implementierung der erfindungsgemäßen Verstärkerschaltung werden keine auf bestimmten Anwendungsgebieten wie der Raumfahrt kritischen Bauteile wie Analog-Digital-Wandler und Multiplexer benötigt.

Eine Ausführungsform der Erfindung betrifft nun eine Verstärkerschaltung mit einem ersten und einem zweiten Schaltelement, die in Reihe zwischen ein erstes und ein zweites Spannungspotential geschaltet sind und im Verstärkerbetrieb getaktet angesteuert werden, wobei zu mindestens einem der beiden Schaltelemente ein kapazitives Element parallel geschaltet ist, einer Messschaltung zum Messen der beim Schalten der Schaltelemente auftretenden Schaltflanken, und einer Stromermittlungsschaltung zum Ermitteln des Ausgangsstroms anhand der gemessenen Schaltflanken.

Das mindestens eine parallel geschaltete kapazitive Element kann durch einen gesonderten Kondensator implementiert sein, der derart bemessen ist, dass beim Schalten der Schaltelemente auftretende Schaltflanken nahezu linear mit einer messbaren Steigung abfallen bzw. ansteigen. Insbesondere ist das mindestens eine kapazitive Element derart gewählt, dass Toleranzeinflüsse der Schaltelemente so weit reduziert werden, dass ihr Einfluss auf Messungen vernachlässigbar gering ist.

Die Messschaltung kann einen Time-to-Digital-Konverter zum Messen einer Zeitspanne einer beim Schalten wenigstens eines der beiden Schaltelemente auftretenden Änderung der Spannung am Mittelpunkt der Reihenschaltung der beiden Schaltelemente aufweisen. Ein Time-to-Digital-Konverter ermöglicht hochgenaue Zeitintervallmessungen, wodurch auch relativ steil abfallende Spannungsflanken zu für die Zwecke der vorliegenden Erfindung brauchbaren Zeitmessungen führen können.

Die Messschaltung kann ausgebildet sein, ein Startsignal beim Über- oder Unterscheiten einer ersten Schwellspannung durch die Spannung am Mittelpunkt der Reihenschaltung der beiden Schaltelemente für einen Messvorgang durch den Time-to-Digital-Konverter und ein Stoppsignal beim Über- oder Unterscheiten einer zweiten Schwellspannung durch die Spannung am Mittelpunkt der Reihenschaltung der beiden Schaltelemente für den Messvorgang durch den Time-to-Digital-Konverter zu erzeugen. Hierdurch kann die Schaltflanke der Spannung am Mittelpunkt der Reihenschaltung der beiden Schaltelemente über einen bestimmten Spannungsbereich gemessen werden, so dass mögliche Messfehler aufgrund beispielsweise von einer schwankenden Versorgungsspannung der Verstärkerschaltung weitgehend eliminiert werden können. Beispielsweise kann bei einer Versorgungsspannung von +25 Volt bis -25 Volt durch die erste und zweite Schwellspannung ein Messbereich zwischen + 5 Volt und - 5 Volt definiert werden, so dass Schwankungen der Versorgungsspannung so gut wie keinen messbaren Einfluss auf die Messungen haben.

Es ist möglich, dass die erste und zweite Schwellspannung nahezu identisch gewählt sind, so dass nur eine Schwelle für die Erzeugung des Start- und Stoppsignals für den Messvorgang durch den Time-to-Digital-Konverter existiert, was zwar zu einer etwas reduzierten Genauigkeit führen, aber dafür schaltungstechnisch einfacher implementiert werden kann. Insbesondere können die beiden identischen Schwellspannungen derart gewählt sein, dass sie etwa in der Mitte des Versorgungsspannungsbereichs der Verstärkerschaltung liegen.

Die Messschaltung kann einen oder mehrere Komparatoren zum Erfassen des Über- oder Unterscheitens der ersten und/oder zweiten Schwellspannung durch die Spannung am Mittelpunkt der Reihenschaltung der beiden Schaltelemente und zum Erzeugen des Start- und/oder Stoppsignals für den Time-to-Digital-Konverter aufweisen. Komparatoren besitzen den Vorteil, dass sie auch für kritische Einsatzgebiete der Verstärkerschaltung wie der Raumfahrt mit entsprechenden Spezifikationen verfügbar sind. Für jede Schwellspannung kann ein eigener Komparator vorgesehen sein. Falls die erste und zweite Schwellspannung identisch gewählt sind, reicht ein einziger Komparator aus, was zu einem geringeren schaltungstechnischen Aufwand beim Implementieren der Verstärkerschaltung führt.

Der Time-to-Digital-Konverter kann durch einen programmierbaren Baustein, insbesondere in FPGA (Field Programable Gate Array), ein ASIC (Application Specific Integrated Circuit) oder einen speziellen Time-to-Digital-Konverter-Baustein implementiert sein.

Die Stromermittlungsschaltung kann ausgebildet sein, mit gemessenen Schaltflanken, insbesondere der gemessenen Zeitspanne der beim Schalten wenigstens eines der beiden Schaltelemente auftretenden Änderung der Spannung am Mittelpunkt der Reihenschaltung der beiden Schaltelemente, und der bekannten Größe des mindestens einen kapazitiven Elements den Ausgangsstrom zu ermitteln. Beispielsweise kann die Stromermittlungsschaltung mit der bekannten Größe des mindestens einen kapazitiven Elements die Zeitkonstante, dem durch die Schwellspannungen definierten Spannungsbereich und der gemessenen Zeitspanne den Lade/Entladestrom des mindestens einen kapazitiven Elements ermitteln, der dem Ausgangsstrom der Verstärkerschaltung entspricht.

Weiterhin kann die Stromermittlungsschaltung ausgebildet sein, einen positiven bzw. einen negativen Ausgangsstrom anhand der bei einer positiven Schaltflanke gemessenen Zeitspanne und der bei einer negativen Schaltflanke gemessenen Zeitspanne zu ermitteln.

Die Stromermittlungsschaltung kann auch ausgebildet sein, die Differenz zwischen der bei einer positiven Schaltflanke gemessenen Zeitspanne und der bei einer negativen Schaltflanke gemessenen Zeitspanne zu ermitteln und eine Kalibration der gemessenen Schaltflanken anhand der ermittelten Differenz durchzuführen. Dies erlaubt insbesondere ein präzises Kalibrieren und führt zu einem nahezu linearen t zu I-Verlauf über eine weiten Bereich.

Die Stromermittlungsschaltung kann ferner ausgebildet sein, beim Ermitteln des Ausgangsstroms anhand der gemessenen Schaltflanken Kalibrationswerte zu berücksichtigen, die bei Kalibrationsmessungen unter bekannten Betriebsbedingungen der Verstärkerschaltung ermittelt wurden, insbesondere bei einem getakteten Verstärkerbetrieb mit einem vorgegeben Tastverhältnis wie beispielsweise 50:50 zum Erzeugen eines bekannten Ausgangsstroms.

Das erste und zweite Spannungspotential können betragsmäßig etwa gleich sein und unterschiedliche Polaritäten aufweisen. In diesem Fall tritt bei einem Schaltvorgang ein Nulldurchgang auf, der von einem Komparator sowohl bei steigender als auch fallender Schaltflanke zuverlässig ermittelt und für die Messung verwendet werden kann.

Das erste Schaltelement kann ein p-Kanal-MOSFET (Metal Oxide Semiconductor Field Effect Transistor) und das zweite Schaltelement ein n-Kanal-MOSFET sein.

Die Verstärkerschaltung nach der Erfindung kann Teil einer Klasse-D-Verstärkerschaltung sein und das erste und zweite Schaltelement können mit einem Pulsweiten-moduliertem Signal angesteuert werden.

Weiterhin kann das mindestens eine kapazitive Element ein Dämpfungsglied zur Strombegrenzung aufweisen, wobei das Dämpfungsglied insbesondere eine Parallelschaltung einer Diode und eines Widerstands aufweist und zwischen einen Anschluss des kapazitiven Elements und einem Anschluss eines der Schaltelemente geschaltet ist. Das Dämpfungsglied kann Schädigungen des mindestens einen kapazitiven Elements durch hohe Ströme vermeiden, die beim Schließen des Schaltelements auftreten können, was ein Kurzschließen des kapazitiven Elements bewirkt.

Weitere Vorteile und Anwendungsmöglichkeiten der vorliegenden Erfindung ergeben sich aus der nachfolgenden Beschreibung in Verbindung mit den in den Zeichnungen dargestellten Ausführungsbeispielen.

In der Beschreibung, in den Ansprüchen, in der Zusammenfassung und in den Zeichnungen werden die in der hinten angeführten Liste der Bezugszeichen verwendeten Begriffe und zugeordneten Bezugszeichen verwendet.

Die Zeichnungen zeigen in

Fig. 1 ein Schaltbild eines Ausführungsbeispiels einer Verstärkerschaltung gemäß der Erfindung;

Fig. 2 einen beispielhaften Verlauf der Eingangsspannung am LC-Filter der in Fig. 1 gezeigten Verstärkerschaltung;

Fig. 3a-c die Stromwege während verschiedener Takt- bzw. Schaltphasen der in Fig. 1 gezeigten Verstärkerschaltung;

Fig. 4 ein Blockschaltbild eines ersten Ausführungsbeispiels der Messschaltung und der Stromermittlungsschaltung gemäß der Erfindung;

Fig. 5 ein Blockschaltbild eines zweiten Ausführungsbeispiels der Messschaltung und der Stromermittlungsschaltung gemäß der Erfindung; und

Fig. 6 ein Diagramm mit gemessenen Komparator-Zeiten bei verschiedenen Strömen.

In der folgenden Beschreibung können gleiche, funktional gleiche und funktional zusammenhängende Elemente mit den gleichen Bezugszeichen versehen sein. Absolute Werte sind im Folgenden nur beispielhaft angegeben und sind nicht als die Erfindung einschränkend zu verstehen.

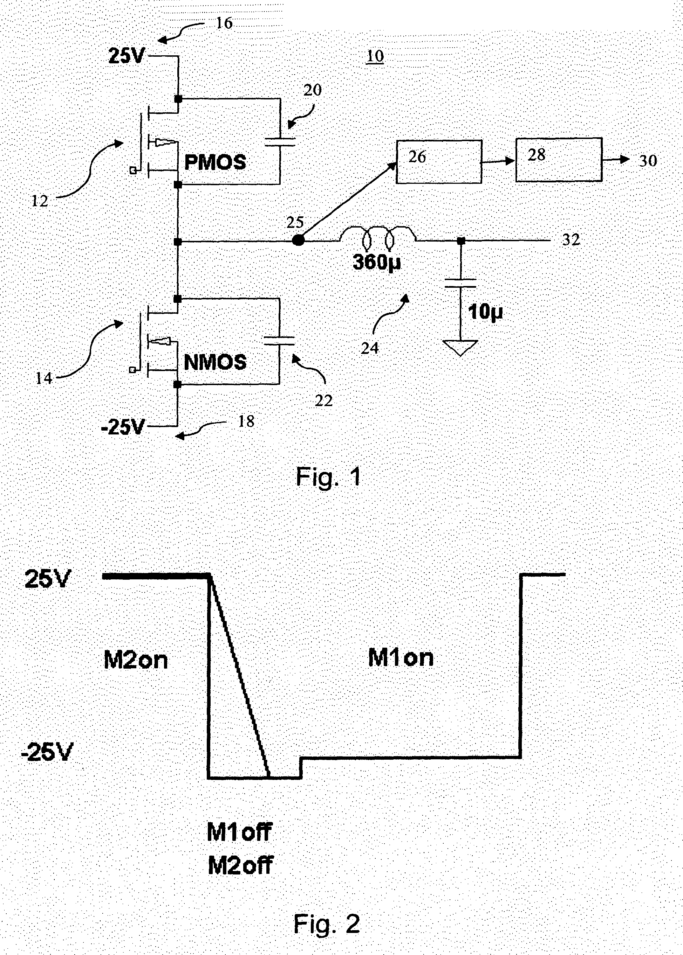

In Fig. 1 ist eine Klasse-D-Verstärkerschaltung 10 zur Ansteuerung eines Elektroantriebs, beispielsweise eine elektrischen Motors gezeigt. Die Verstärkerschaltung 10 umfasst einen p-Kanal-MOSFET (PMOS) 12 als erstes Schaltelement und einen n-Kanal-MOSFET (NMOS) 14 als zweites Schaltelement. Die beiden MOSFETs 12 und 14 sind in Reihe zwischen ein erstes positives Potential 16, beispielsweise +25 Volt, und ein zweites negatives Potential 18, beispielsweise -25 Volt, geschaltet. Parallel zu den Kanälen der beiden MOSFETs 12 und 14 ist jeweils ein erster bzw. zweiter Kondensator 20 bzw. 22 als kapazitives Element zur Minimierung von Toleranzeinflüssen der MOSFETs auf das Umschalten der Spannung am Mittelpunkt der Reihenschaltung der beiden MOSFETs 12 und 14 geschaltet.

Ein LC-Tiefpaßfilter 24 mit einer Spule 360μ und einem Kondensator 10μ ist eingangsseitig mit dem Mittelpunkt der Reihenschaltung der beiden MOSFETs 12 und 14 verbunden. Der Filter 24 bewirkt, dass der Ausgangsstrom der Verstärkerschaltung 10 am Verstärkerausgang 32 im getakteten Betrieb insbesondere während einer Umschaltphase weitgehend konstant ist. Der LC-Tiefpaßfilter 24 ist schaltungstechnisch für die Implementierung der vorliegenden Erfindung grundsätzlich nicht erforderlich. Anstelle des LC-Tiefpaßfilters 24 kann auch eine einzelne Induktivität wie eine Spule oder eine induktive Last wie ein elektrischer Motor vorgesehen sein.

Die Eingangsspannung 25 am LC-Tiefpaßfilter 24, die der Spannung am Mittelpunkt der Reihenschaltung der beiden MOSFETs 12 und 14 entspricht, wird einer Messschaltung 26 zugeführt, der eine Stromermittlungsschaltung 28 zum Ermitteln und Ausgeben des Ausgangsstrom-Messwerts 30 der Verstärkerschaltung 10 nachgeschaltet ist.

Die beiden MOSFETs 12 und 14 werden mit einem PWM-Signal getaktet betrieben. Während der Totzeit beim Umschalten der beiden MOSFETs 12 und 14 werden die parallel zu den MOSFETs geschalteten Kondensatoren 20 und 22 durch den aufgrund des LC-Tiefpaßfilters 24 weitgehend konstanten Ausgangsstrom umgeladen. Dies führt zu einer nahezu linear abfallenden bzw. ansteigenden Spannungsflanke der Eingangsspannung 25 des LC-Tiefpaßfilters 24, wie in Fig, 2 anhand des beispielhaften Verlaufs der Eingangsspannung 25 am LC-Tiefpaßfilter 24 für verschiedene Schaltphasen der Verstärkerschaltung 10 dargestellt ist. Im Diagramm von Fig, 2 ist der p-Kanal-MOSFET 12 mit M2 und der n-Kanal-MOSFET 14 mit M1 bezeichnet. Die ideal verlaufende Eingangsspannung 25 ist mit unendlich steilen Flanken dargestellt und verläuft zwischen dem positiven und dem negativen Potential von etwa +25 Volt und -25 Volt. Die durch die Kondensatoren 20 und 22 bewirkte linear abfallende Flanke der Eingangsspannung 25 beim Umschalten der MOSFETs 12 und 14 ist als schräge Flanke gezeigt. Die Steigung dieser schrägen Flanke ist direkt proportional zum Ausgangsstrom der Verstärkerschaltung 10.

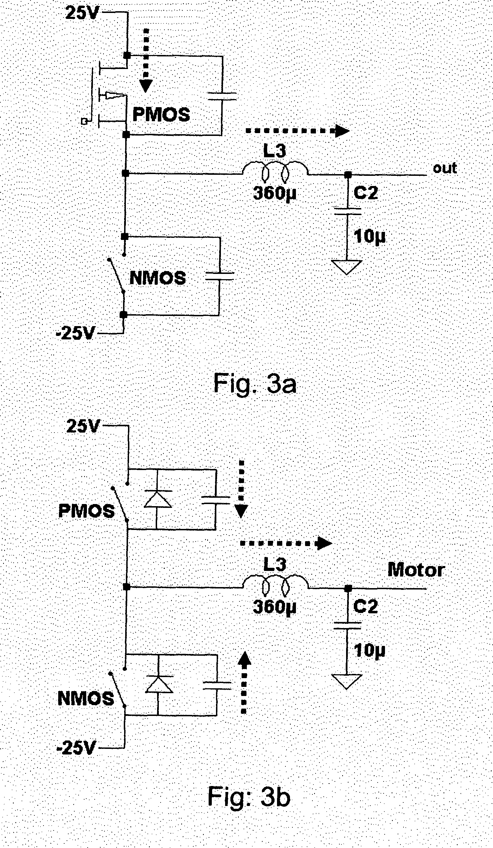

Die Umschaltvorgänge und die dabei auftretenden Stromwege sind in den Fig. 3a-3c gezeigt.

In Fig. 3a ist eine Schaltphase dargestellt, bei welcher der Kanal des p-Kanal-MOSFET PMOS offen und der Kanal des n-Kanal-MOSFET NMOS gesperrt ist. Als Eingangsspannung liegt daher das positive Potential +25V (Volt) am Eingang des LC-Tiefpaßfilters, und der durch die gepunkteten fettgedruckten Pfeile verdeutlichte Stromfluss geht vom positiven Potential +25V über die Spule L3 des LC-Tiefpaßfilters zum Verstärkerausgang "out".

In Fig. 3b sind die Kanäle beider MOSFETs PMOS und NMOS gesperrt, wie durch die offenen Schalter angedeutet ist. In diesem Fall wirken die MOSFETs PMOS und NMOS wie die angedeuteten Dioden und in den parallel zu den MOSFETs geschalteten Kondensatoren gespeicherter Ladung fließt als Strom (durch die gepunkteten fettgedruckten Pfeile angedeutet) über die Spule L3 des LC-Tiefpaßfilters zum Verstärkerausgang in einen daran angeschlossenen elektrischen Motor.

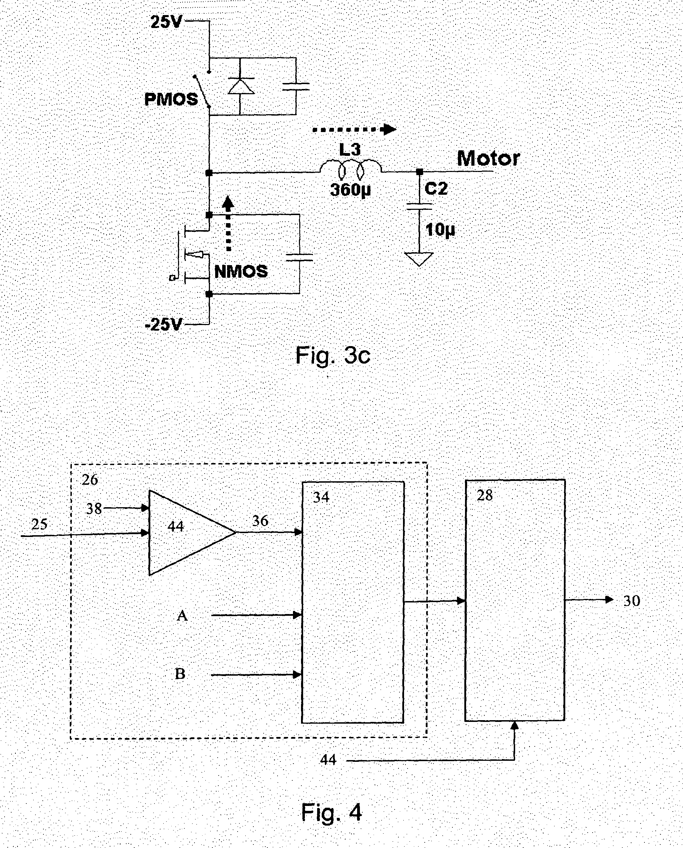

In Fig. 3c ist schließlich eine Schaltphase dargestellt, bei welcher der Kanal des n-Kanal-MOSFET NMOS offen und der Kanal des p-Kanal-MOSFET PMOS gesperrt ist. Als Eingangsspannung liegt daher das negative Potential - 25V (Volt) am Eingang des LC-Tiefpaßfilters, und der durch die gepunkteten fettgedruckten Pfeile verdeutlichte Stromfluss geht vom negativen Potential - 25V über die Spule L3 des LC-Tiefpaßfilters zum Verstärkerausgang "out" in den daran angeschlossenen elektrischen Motor.

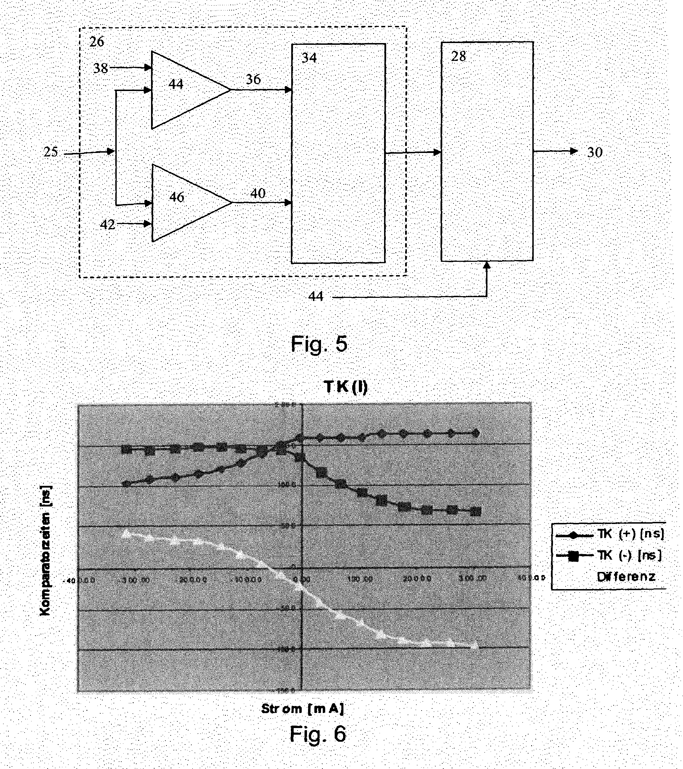

Im Folgenden wird nun unter Bezug auf die in Fig. 4 und 5 gezeigten Ausführungsbeispiele der Messschaltung und der Stromermittlungsschaltung gemäß der Erfindung erläutert, wie die beim Schalten der Schaltelemente auftretenden Schaltflanken gemessen werden können, und wie daraus der Ausgangsstrom ermittelt werden kann.

In dem in Fig. 4 gezeigten Ausführungsbeispiel weist die Messschaltung 26 einen einzigen Komparator 44 auf, der die Eingangsspannung 25 des LC-Tiefpaßfilters 24 mit einer Schwellspannung 38 vergleicht, die derart gewählt ist, dass sie etwa in der Mitte zwischen dem ersten positiven und dem zweiten negativen Potential 16 bzw. 18 liegt, also etwa bei 0 Volt. Der Komparator 44 detektiert demnach einen Nulldurchgang der Eingangsspannung 25. Das vom Komparator 44 erzeugte digitale Signal 36 ändert seinen Zustand bei einem Nulldurchgang, beispielsweise wenn die Eingangsspannung 25 absinkt (fallende bzw. negative Schaltflanke) und die Schwellspannung 38 unterschreitet oder wenn die Eingangsspannung 25 ansteigt (steigende bzw. positive Schaltflanke) und die Schwellspannung 38 überschreitet.

Das digitale Ausgangssignal 36 des Komparators 44 wird zusammen mit den Schaltsignalen A und B der MOSFETs 12 und 14 einem Time-to-Digital-Konverter 34 zum Messen kurzer Zeitintervalle zugeführt. Der Time-to-Digital-Konverter 34 beginnt eine Messung eines kurzen Zeitintervalls, wenn sich der Schaltzustand eines der Schaltsignale A oder B ändert und beide Schaltsignale A und B einen solchen Zustand aufweisen, dass beide MOSFETs 12 und 14 gesperrt sind (siehe Fig. 3b), und stoppt diese Messung, wenn sich der Schaltzustand des digitalen Signals 36 ändert. Der vom Time-to-Digital-Konverter 34 gemessene Wert des durch die Signalzustandsänderungen definierten Zeitintervalls wird als digitaler Zeitintervalls-Messwert an die Stromermittlungsschaltung 28 ausgegeben, die daraus den Ausgangsstrom ermittelt.

Die genaue Funktionsweise der in Fig. 4 gezeigten Messschaltung 26 und der Stromermittlungsschaltung 28 wird nun anhand des in Fig. 2 gezeigten beispielhaften Verlaufs der Eingangsspannung 25 erläutert.

Zunächst befindet sich die Verstärkerschaltung in dem in Fig. 3a gezeigten Zustand, in dem der NMOS 14 abgeschaltet ist. In einer Umschaltphase wird auch der PMOS 12 abgeschaltet (Fig. 3b), d.h. das Schaltsignal A ändert zum Zeitpunkt tA seinen Zustand, wodurch der Time-to-Digital-Konverter 34 mit der Messung eines kurzen Zeitintervalls beginnt. Wie in Fig. 2 gezeigt fällt nun die Eingangsspannung 25 von +25 Volt auf -25 Volt, wobei durch die den MOSFETs parallel geschalteten Kondensatoren 20 und 22 eine Verzögerung des Spannungsabfalls bewirkt wird, wie durch die schräg abfallende Linie in Fig. 2 angedeutet ist.

Der Komparator 44 vergleicht die abfallende Eingangsspannung 25 mit der Schwellspannung von beispielsweise 0 Volt und ändert den Zustand des Ausgangssignals 36 beispielsweise von binär 0 auf 1 zum Zeitpunkt tK1 sobald der Schwellwert 38 durch die Eingangsspannung 25 unterschritten wird, wodurch die Messung durch den Time-to-Digital-Konverter 34 beendet und der digitale Messwert des Zeitintervalls T1 = tA-tK1 an die Stromermittlungsschaltung 28 ausgegeben wird.

Eine ähnliche Funktionsweise weist die Messschaltung 26 auf, wenn die Verstärkerschaltung von dem in Fig. 3c gezeigten Zustand, in dem der PMOS 12 abgeschaltet ist, in den in Fig. 3b gezeigten Zustand wechselt, also der NMOS 14 abgeschaltet wird, d.h. das Schaltsignal B seinen Zustand zum Zeitpunkt tB ändert. Hierdurch wird der Time-to-Digital-Konverter 34 getriggert, um mit der Messung eines kurzen Zeitintervalls zu beginnen. Die Eingangsspannung 25 steigt nun von -25 Volt auf +25 Volt, wobei durch die den MOSFETs parallel geschalteten Kondensatoren 20 und 22 wieder eine Verzögerung des Spannungsanstiegs bewirkt wird. Der Komparator 44 vergleicht die ansteigende Eingangsspannung 25 mit der Schwellspannung von 0 Volt und ändert den Zustand des Ausgangssignals 36 beispielsweise von binär 1 auf 0 zum Zeitpunkt tK2 sobald der Schwellwert 38 durch die Eingangsspannung 25 überschritten wird, wodurch die Messung durch den Time-to-Digital-Konverter 34 beendet und der digitale Messwert des Zeitintervalls T2 = tB-tK2 an die Stromermittlungsschaltung 28 ausgegeben wird.

Die Abhängigkeit der Komparator-Messzeiten (Zeiten, zu denen sich das Ausgangssignal 36 des Komparators 44 ändert, da die Eingangsspannung 25 die Schwellspannung über- oder unterschreitet) von den zu ermittelnden Strömen ist beispielhaft in dem in Fig. 6 gezeigten Diagramm dargestellt. Über die Abszisse sind elektrische Stromstärken auftragen, über die Ordinate die vom Strom abhängige und gemessene Komparatorzeit TK(I). Die mit TK(+) bezeichnete Messkurve zeigt die Komparatorzeiten bei steigender Schaltflanke und die mit TK(-) bezeichnete Messkurve die Komparatorzeiten bei fallender Schaltflanke. Bei steigender Schaltflanke ist die Abhängigkeit der Komparatorzeit vom Strom bei negativen Strömen nahezu linear. Dagegen ist bei fallender Schaltflanke die Abhängigkeit der Komparatorzeit vom Strom bei positiven Strömen nahezu linear. Über den gesamten Strombereich kann daher durch eine Differenz der gemessenen Komparatorzeiten bei steigender und fallender Schaltflanke eine nahezu lineare Abhängigkeit erzielt werden, wie die mit "Differenz" im Diagramm bezeichnete Kurve zeigt. Die Offsetwerte der mit TK(+) und TK(-) bezeichneten Messkurven resultieren aus der unvermeidbaren Verzögerungszeit zwischen der Zustandsänderung eines Schaltsignals eines der MOSFETs 12 und 14 und der tatsächlichen Abschaltung des MOSFETs 12 bzw. 14. Durch die Differenzbildung kann dieser Offset kompensiert werden, wenn auch nicht vollständig.

Die Stromermittlungsschaltung 28 ermittelt nun anhand des digitalen Messwerts des Zeitintervalls T1 bzw. T2, der bekannten Werte der beiden Kondensatoren 20 und 22 anhand der bekannten physikalischen Zusammenhänge beim Laden und Entladen von Kondensatoren den Ausgangsstrom des Verstärkerschaltung 10. Beispielsweise kann die Stromermittlungsschaltung 28 bei einer fallenden Schaltflanke der Eingangsspannung 25 (UEingang) und einer Versorgungsspannung Vcc den Strom I0 im Kondensator gemäß der folgenden Gleichung ermitteln:

$$UEingang = Vcc - I0/C*t,$$

wobei C die Kapazität des ersten Kondensators 20 angibt. Für den Parameter t kann ein gemessenes Zeitintervall T0 eingesetzt werden. Aus der obigen Gleichung ergibt sich, dass T0 proportional zu 1/I0 ist. Die reziproke Funktion 1/x kann jedoch durch eine lineare Funktion approximiert werden, so dass ein linearer Zusammenhang zwischen dem gemessenen Zeitintervall T0 und dem Strom I0 hergestellt werden kann, der von der Stromermittlungsschaltung 28 zum Ermitteln des Stromes bei bekannter Kapazität des ersten und zweiten Kondensators 20 bzw. 22 und bekannter Versorgungsspannung Vcc und Eingangsspannung UEingang herangezogen werden kann.

Bei der Ermittlung des Ausgangsstroms kann die Stromermittlungsschaltung 28 ferner Kalibrationswerte 44 berücksichtigen, die durch Kalibrationsmessungen ermittelt wurden. Diese Kalibrationsmessungen können unter bekannten Bedingungen durchgeführt werden, beispielsweise bei einem genau vorgegebenen Tastverhältnis bei einem getakteten Verstärkerbetrieb, beispielsweise einem Tastverhältnis 50:50 zum Erzeugen eines bekannten und genau definierten Ausgangsstroms. Die Kalibrationsmessungen und die damit ermittelten Kalibrationswerte dienen vor allem dazu, Fehlereinflüsse durch beispielsweise Bauteiletoleranzen, Temperatureffekte oder externe Einflüsse wie beispielsweise durch die Versorgungsspannung der Verstärkerschaltung zu minimieren.

In dem in Fig. 5 gezeigten Ausführungsbeispiel weist die Messschaltung 26 anstelle eines einzelnen Komparators einen ersten Komparator 44 und einen zweiten Komparator 46 auf, welche die Eingangsspannung 25 des LC-Tiefpaßfilters 24 mit einer ersten Schwellspannung 38 bzw. einer zweiten Schwellspannung 42 vergleichen. Die erste Schwellspannung 38 kann beispielsweise +5 Volt und die zweite Schwellspannung 42 -5 Volt betragen. Alternativ kann auch die erste Schwellspannung 38 0 Volt sein, so dass ein Nulldurchgang der Eingangsspannung 25 detektiert wird, und die zweite Schwellspannung 42 entweder +25 Volt (Messung steigende Flanke) oder -25 Volt (Messung fallende Flanke) sein.

Der erste Komparator 44 erzeugt ein digitales Startsignal 36 für eine Zeitmessung, der zweite Komparator 46 ein digitales Stoppsignal 40. Beide Signale 36 und 40 werden einem Time-to-Digital-Konverter 34 zum Messen kurzer Zeitintervalle zugeführt. Der Time-to-Digital-Konverter 34 beginnt eine Messung eines kurzen Zeitintervalls, wenn sich der Schaltzustand des digitalen Startsignals 36 ändert, und stoppt diese Messung, wenn sich der Schaltzustand des digitalen Stoppsignals 40 ändert. Der vom Time-to-Digital-Konverter 34 gemessene Wert des durch die Signalzustandsänderungen des Start- und Stoppsignals definierten Zeitintervalls wird als digitaler Zeitintervalls-Messwert an die Stromermittlungsschaltung 28 ausgegeben, die daraus den Ausgangsstrom ermittelt.

Die genaue Funktionsweise der in Fig. 5 gezeigten Messschaltung 26 und der Stromermittlungsschaltung 28 wird nun anhand des in Fig. 2 gezeigten beispielhaften Verlaufs der Eingangsspannung 25 gezeigt.

Zunächst befindet sich die Verstärkerschaltung in dem in Fig. 3a gezeigten Zustand, in dem der NMOS 14 abgeschaltet ist. In einer Umschaltphase wird auch der PMOS 12 abgeschaltet (Fig. 3b). Dadurch fällt wie in Fig. 2 gezeigt die Eingangsspannung 25 von +25 Volt auf -25 Volt, wobei durch die den MOSFETs parallel geschalteten Kondensatoren 20 und 22 eine Verzögerung des Spannungsabfalls bewirkt wird, wie durch die schräg abfallende Linie in Fig. 2 angedeutet ist.

Der erste Komparator 44 vergleicht die abfallende Eingangsspannung 25 mit der ersten Schwellspannung von beispielsweise +5 Volt (oder 0 Volt) und ändert den Zustand des Startsignals 36 beispielsweise von binär 0 auf 1 sobald der erste Schwellwert 38 durch die Eingangsspannung 25 unterschritten wird. Die Zustandsänderung des Startsignals 36 bewirkt, dass der Time-to-Digital-Konverter 34 mit der Messung eines kurzen Zeitintervalls beginnt. Wenn die weiter absinkende Eingangsspannung 25 auch den zweiten Schwellwert 42 von beispielsweise -5 Volt (oder -25 Volt) unterschreitet, ändert der zweite Komparator 46 den Zustand des Stoppsignals 40 beispielsweise von binär 0 auf 1, wodurch die Messung durch den Time-to-Digital-Konverter 34 beendet und der digitale Messwert des Zeitintervalls an die Stromermittlungsschaltung 28 ausgegeben wird.

Die Stromermittlungsschaltung 28 ermittelt nun anhand des digitalen Messwerts des Zeitintervalls, der bekannten Werte der beiden Kondensatoren 20 und 22 anhand der bekannten physikalischen Zusammenhänge beim Laden und Entladen von Kondensatoren den Ausgangsstrom des Verstärkerschaltung 10. Bei der Ermittlung des Ausgangsstroms kann die Stromermittlungsschaltung 28 ferner Kalibrationswerte 44 berücksichtigen, die durch Kalibrationsmessungen ermittelt wurden. Diese Kalibrationsmessungen können unter bekannten Bedingungen durchgeführt werden, beispielsweise bei einem genau vorgegebenen Tastverhältnis bei einem getakteten Verstärkerbetrieb, beispielsweise einem Tastverhältnis 50:50 zum Erzeugen eines bekannten und genau definierten Ausgangsstroms. Die Kalibrationsmessungen und die damit ermittelten Kalibrationswerte dienen vor allem dazu, Fehlereinflüsse durch beispielsweise Bauteiletoleranzen, Temperatureffekte oder externe Einflüsse wie beispielsweise durch die Versorgungsspannung der Verstärkerschaltung zu minimieren.

Die vorliegende Erfindung ermöglicht es, den Bauteile- und Schaltungsaufwand bei der Messung des Ausgangsstroms einer getaktet betriebenen Verstärkerschaltung zu reduzieren, was vor allem in bestimmten Anwendungsgebieten wie der Raumfahrt von Vorteil sein kann, da keine Bauteile benötigt werden, die hinsichtlich mancher Anwendungsgebiete aus verschiedenen Gründen kritisch sind, wie beispielsweise Analog-Digital-Wandler oder Multiplexer. Der für die Messung erforderliche Bauteileaufwand reduziert sich durch die Erfindung auf wenige kapazitive Elemente und einer einfachen Stromermittlungsschaltung insbesondere mit wenigen Komparatoren.

BEZUGSZEICHEN UND AKRONYME

10    Klasse-D-Verstärkerschaltung
12    p-Kanal-MOSFET
14    n-Kanal-MOSFET
16    positives Potential
18    negatives Potential
20    erster Kondensator
22    zweiter Kondensator
24    LC-Tiefpaßfilter
25    Eingangsspannung des LC-Tiefpaßfilters 24
26    Messschaltung
28    Stromermittlungsschaltung
30    Ausgangsstrom-Messwert
32    Verstärkerausgang
34    Time-to-Digital-Konverter
36    Startsignal
38    erste Schwellspannung
40    Stoppsignal
42    zweite Schwellspannung
44    Kalibrationswerte
A     Schaltsignal des p-Kanal-MOSFET 12
B     Schaltsignal des n-Kanal-MOSFET 14

**Patentansprüche**

1.  Verstärkerschaltung (10) mit

    - einem ersten und einem zweiten Schaltelement (12, 14), die in Reihe zwischen ein erstes und ein zweites Spannungspotential (16, 18) geschaltet sind und im Verstärkerbetrieb getaktet angesteuert werden, wobei zu mindestens einem der beiden Schaltelemente ein kapazitives Element (20, 22) parallel geschaltet ist,
    - einer Messschaltung (26) zum Messen der beim Schalten der Schaltelemente auftretenden Schaltflanken, und
    - einer Stromermittlungsschaltung (28) zum Ermitteln des Ausgangsstroms (30) anhand der gemessenen Schaltflanken.

2.  Verstärkerschaltung nach Anspruch 1,
    **dadurch gekennzeichnet, dass**
    die Messschaltung einen Time-to-Digital-Konverter (34) zum Messen einer Zeitspanne einer beim Schalten wenigstens eines der beiden Schaltelemente auftretenden Änderung der Spannung (25) am Mittelpunkt der Reihenschaltung der beiden Schaltelemente aufweist.

3.  Verstärkerschaltung nach Anspruch 2,
    **dadurch gekennzeichnet, dass**
    die Messschaltung ausgebildet ist, ein Startsignal (36) beim Über- oder Unterscheiten einer ersten Schwellspannung (38) durch die Spannung (25) am Mittelpunkt der Reihenschaltung der beiden Schaltelemente für einen Messvorgang durch den Time-to-Digital-Konverter und ein Stoppsignal (40) beim Über- oder Unterscheiten einer zweiten Schwellspannung (42) durch die Spannung (25) am Mittelpunkt der Reihenschaltung der beiden Schaltelemente für den Messvorgang durch den Time-to-Digital-Konverter zu erzeugen.

4.  Verstärkerschaltung nach Anspruch 3,
    **dadurch gekennzeichnet, dass**
    die erste und zweite Schwellspannung nahezu identisch gewählt sind, und insbesondere die beiden nahezu identischen Schwellspannungen derart gewählt sind, dass sie etwa in der Mitte des Versorgungsspannungsbereichs der Verstärkerschaltung liegen.

5.  Verstärkerschaltung nach Anspruch 3 oder 4,
    **dadurch gekennzeichnet, dass**
    die Messschaltung einen oder mehrere Komparatoren (44, 46) zum Erfassen des Über- oder Unterscheitens der ersten und/oder zweiten Schwellspannung durch die Spannung (25) am Mittelpunkt der Reihenschaltung der beiden Schaltelemente und zum Erzeugen des Start- und/oder Stoppsignals für den Time-to-Digital-Konverter aufweist.

6.  Verstärkerschaltung nach Anspruch 2, 3 oder 4,
    **dadurch gekennzeichnet, dass**
    der Time-to-Digital-Konverter durch einen programmierbaren Baustein, insbesondere in FPGA, ein ASIC oder einen speziellen Time-to-Digital-Konverter-Baustein implementiert ist.

7.  Verstärkerschaltung nach einem der vorhergehenden Ansprüche,
    ferner **dadurch gekennzeichnet dass**
    die Stromermittlungsschaltung ausgebildet ist, mit gemessenen Schaltflanken, insbesondere der gemessenen Zeitspanne der beim Schalten wenigstens eines der beiden Schaltelemente auftretenden Änderung der Spannung (25) am Mittelpunkt der Reihenschaltung der beiden Schaltelemente, und der bekannten Größe des mindestens einen kapazitiven Elements den Ausgangsstrom zu ermitteln.

8.  Verstärkerschaltung nach Anspruch 7,

**dadurch gekennzeichnet, dass**
die Stromermittlungsschaltung ausgebildet ist, einen positiven bzw. einen negativen Ausgangsstrom anhand der bei einer positiven Schaltflanke gemessenen Zeitspanne und der bei einer negativen Schaltflanke gemessenen Zeitspanne zu ermitteln.

9. Verstärkerschaltung nach Anspruch 8,
**dadurch gekennzeichnet, dass**
die Stromermittlungsschaltung ausgebildet ist, die Differenz zwischen der bei einer positiven Schaltflanke gemessenen Zeitspanne und der bei einer negativen Schaltflanke gemessenen Zeitspanne zu ermitteln und eine Kalibration der gemessenen Schaltflanken anhand der ermittelten Differenz durchzuführen.

10. Verstärkerschaltung nach einem der vorhergehenden Ansprüche,
ferner **dadurch gekennzeichnet dass**
die Stromermittlungsschaltung ausgebildet ist, beim Ermitteln des Ausgangsstroms anhand der gemessenen Schaltflanken Kalibrationswerte (44) zu berücksichtigen, die bei Kalibrationsmessungen unter bekannten Betriebsbedingungen der Verstärkerschaltung ermittelt wurden, insbesondere bei einem getakteten Verstärkerbetrieb mit einem Tastverhältnis 50:50 zum Erzeugen eines bekannten Ausgangsstroms.

11. Verstärkerschaltung nach einem der vorhergehenden Ansprüche,
**dadurch gekennzeichnet, dass**
das erste und zweite Spannungspotential betragsmäßig etwa gleich sind und unterschiedliche Polaritäten aufweisen.

12. Verstärkerschaltung nach einem der vorhergehenden Ansprüche,
**dadurch gekennzeichnet, dass**
das erste Schaltelement ein p-Kanal-MOSFET ist und das zweite Schaltelement ein n-Kanal-MOSFET ist.

13. Verstärkerschaltung nach einem der vorhergehenden Ansprüche,
**dadurch gekennzeichnet, dass**
sie Teil einer Klasse-D-Verstärkerschaltung ist und das erste und zweite Schaltelement mit einem Pulsweiten-modulierten Signal angesteuert werden.

14. Verstärkerschaltung nach einem der vorhergehenden Ansprüche,
**dadurch gekennzeichnet, dass**
das mindestens eine kapazitive Element (20, 22) ein Dämpfungsglied zur Strombegrenzung aufweist, wobei das Dämpfungsglied insbesondere eine Parallelschaltung einer Diode und eines Widerstands aufweist und zwischen einen Anschluss des kapazitiven Elements und einem Anschluss eines der Schaltelemente geschaltet ist.

**Claims**

1. Amplifier circuit (10) having

    - a first and a second switching element (12, 14) which are connected in series between a first and a second voltage potential (16, 18) and are driven in a clocked manner in amplifier operation, wherein a capacitive element (20, 22) is connected in parallel with at least one of the two switching elements,
    - a measuring circuit (26) for measuring the switching edges which occur during switching of the switching elements, and
    - a current determination circuit (28) for determining the output current (30) on the basis of the measured switching edges.

2. Amplifier circuit according to Claim 1,
**characterized in that**
the measuring circuit has a time-to-digital converter (34) for measuring a time interval of a change in the voltage (25) at the centre point of the series connection composed of the two switching elements which occurs when at least one of the two switching elements is switched.

3. Amplifier circuit according to Claim 2,
**characterized in that**
the measuring circuit is designed to generate a start signal (36) for a measuring process by the time-to-digital converter when a first threshold voltage (38) is exceeded or is not reached by the voltage (25) at the centre point of the series connection composed of the two switching elements, and to generate a stop signal (40) for the measuring process by the time-to-digital converter when a second threshold voltage (42) is exceeded or is not reached by the voltage (25) at the centre point of the series connection composed of the two switching elements.

4. Amplifier circuit according to Claim 3,
**characterized in that**
the first and second threshold voltages are selected to be almost identical and, in particular, the two almost identical threshold voltages are selected such that they lie approximately in the middle of the supply voltage range of the amplifier circuit.

5. Amplifier circuit according to Claim 3 or 4,
**characterized in that**
the measuring circuit has one or more comparators (44, 46) for detecting when the first and/or second threshold voltage is exceeded or not reached by the voltage (25) at the centre point of the series connection composed of the two switching elements and for generating the start and/or stop signal for the time-to-digital converter.

6. Amplifier circuit according to Claim 2, 3 or 4, **characterized in that** the time-to-digital converter is implemented by a programmable component, in particular an FPGA, an ASIC or a specific time-to-digital-converter component.

7. Amplifier circuit according to any of the preceding claims, further **characterized in that** the current determination circuit is designed to determine the output current, with measured switching edges, in particular, of the measured time interval of the change in the voltage (25) at the centre point of the series connection composed of the two switching elements which occurs when at least one of the two switching elements is switched, and of the known variable of the at least one capacitive element.

8. Amplifier circuit according to Claim 7, **characterized in that** the current determination circuit is designed to determine a positive or a negative output current on the basis of the time interval measured in the event of a positive switching edge and the time interval measured in the event of a negative switching edge.

9. Amplifier circuit according to Claim 8, **characterized in that** the current determination circuit is designed to determine the difference between the time interval measured in the event of a positive switching edge and the time interval measured in the event of a negative switching edge, and to perform a calibration of the measured switching edges on the basis of the determined difference.

10. Amplifier circuit according to any of the preceding claims, further **characterized in that** the current determination circuit is designed to take into account calibration values (44) when determining the output current on the basis of the measured switching edges, which calibration values were determined during calibration measurements under known operating conditions of the amplifier circuit, in particular in the event of a clocked amplifier operation with a duty ratio of 50:50 to generate a known output current.

11. Amplifier circuit according to any of the preceding claims,

**characterized in that** the first and second voltage potentials are approximately equal in terms of magnitude and have different polarities.

12. Amplifier circuit according to any of the preceding claims, **characterized in that** the first switching element is a p-channel MOSFET and the second switching element is an n-channel MOSFET.

13. Amplifier circuit according to any of the preceding claims, **characterized in that** it is part of a class D amplifier circuit and the first and second switching elements are driven using a pulse-width-modulated signal.

14. Amplifier circuit according to any of the preceding claims, **characterized in that** the at least one capacitive element (20, 22) has an attenuator for current limiting, wherein the attenuator has, in particular, a parallel connection composed of a diode and a resistor and is connected between a connection of the capacitive element and a connection of one of the switching elements.

**Revendications**

1. Circuit amplificateur (10) comprenant

   - un premier et un deuxième élément de commutation (12, 14) qui sont branchés en série entre un premier et un deuxième potentiel de tension (16, 18) et qui, en régime d'amplification, sont excités de manière cadencée, un élément capacitif (20, 22) étant branché en parallèle par rapport au moins à un des deux éléments de commutation,
   - un circuit de mesure (26) destiné à mesurer les fronts de commutation produits lors de la commutation des éléments de commutation, et
   - un circuit de détermination de courant (28) destiné à déterminer le courant de sortie (30) au moyen des fronts de commutation mesurés.

2. Circuit amplificateur selon la revendication 1, **caractérisé en ce que** le circuit de mesure présente un convertisseur temps/numérique (34) destiné à mesurer un intervalle de temps d'une modification de la tension (25) qui se produit au point milieu du circuit série des deux éléments de commutation lors de la commutation d'au moins l'un des deux éléments de commutation.

**3.** Circuit amplificateur selon la revendication 2, **caractérisé en ce que** le circuit de mesure est configuré pour générer un signal de départ (36) en cas de franchissement dans un sens ou dans l'autre d'une première tension de seuil (38) par la tension (25) au point milieu du circuit série des deux éléments de commutation pour une opération de mesure par le convertisseur temps/numérique et un signal d'arrêt (40) en cas de franchissement dans un sens ou dans l'autre d'une deuxième tension de seuil (42) par la tension (25) au point milieu du circuit série des deux éléments de commutation pour l'opération de mesure par le convertisseur temps/numérique.

**4.** Circuit amplificateur selon la revendication 3, **caractérisé en ce que** la première et la deuxième tension de seuil sont choisies quasiment identiques et les deux tensions de seuil quasiment identiques sont notamment choisies de telle sorte qu'elles se trouvent approximativement au centre de la plage de tensions d'alimentation du circuit amplificateur.

**5.** Circuit amplificateur selon la revendication 3 ou 4, **caractérisé en ce que** le circuit de mesure présente un ou plusieurs comparateurs (44, 46) destinés à détecter le franchissement dans un sens ou dans l'autre de la première et/ou deuxième tension de seuil par la tension (25) au point milieu du circuit série des deux éléments de commutation et à générer le signal de départ et/ou d'arrêt pour le convertisseur temps/numérique.

**6.** Circuit amplificateur selon la revendication 2, 3 ou 4, **caractérisé en ce que** le convertisseur temps/numérique est mis en oeuvre par un composant programmable, notamment dans un FPGA, un ASIC ou un composant convertisseur temps/numérique spécial.

**7.** Circuit amplificateur selon l'une des revendications précédentes, caractérisé en outre en ce que le circuit de détermination de courant est configuré pour déterminer le courant de sortie avec les fronts de commutation mesurés, notamment l'intervalle de temps mesuré de la modification de la tension (25) qui se produit au point milieu du circuit série des deux éléments de commutation lors de la commutation d'au moins l'un des deux éléments de commutation, et avec la grandeur connue de l'au moins un élément capacitif.

**8.** Circuit amplificateur selon la revendication 7, **caractérisé en ce que** le circuit de détermination de courant est configuré pour déterminer un courant de sortie positif ou négatif à l'aide de l'intervalle de temps mesuré lors d'un front de commutation positif et de l'intervalle de temps mesuré lors d'un front de commutation négatif.

**9.** Circuit amplificateur selon la revendication 8, **caractérisé en ce que** le circuit de détermination de courant est configuré pour déterminer la différence entre l'intervalle de temps mesuré lors d'un front de commutation positif et l'intervalle de temps mesuré lors d'un front de commutation négatif et effectuer un calibrage des fronts de commutation mesurés à l'aide de la différence déterminée.

**10.** Circuit amplificateur selon l'une des revendications précédentes, caractérisé en outre en ce que le circuit de détermination de courant est configuré pour tenir compte, lors de la détermination du courant de sortie à l'aide des fronts de commutation mesurés, des valeurs de calibrage (44) qui ont été déterminées lors des mesures de calibrage sous des conditions de fonctionnement connues du circuit amplificateur, notamment lors d'un régime d'amplification cadencé avec un rapport cyclique de 50:50 en vue de générer un courant de sortie connu.

**11.** Circuit amplificateur selon l'une des revendications précédentes, **caractérisé en ce que** les valeurs du premier et du deuxième potentiel de tension sont approximativement égales et présentent des polarités différentes.

**12.** Circuit amplificateur selon l'une des revendications précédentes, **caractérisé en ce que** le premier élément de commutation est un MOSFET à canal P et le deuxième élément de commutation est un MOSFET à canal N.

**13.** Circuit amplificateur selon l'une des revendications précédentes, **caractérisé en ce qu'**il fait partie d'un circuit amplificateur de classe D et le premier et le deuxième élément de commutation sont excités avec un signal modulé en largeur d'impulsion.

**14.** Circuit amplificateur selon l'une des revendications précédentes, **caractérisé en ce que** l'au moins un élément capacitif (20, 22) présente un élément atténuateur destiné à la limitation du courant, l'élément atténuateur présentant notamment un circuit parallèle d'une diode et d'une résistance et étant branché entre une borne de l'élément capacitif et une borne de l'un des éléments de commutation.

Fig. 1

Fig. 2

Fig. 3a

Fig: 3b

— not applicable

Fig. 3c

Fig. 4

Fig. 5

Fig. 6